Europäisches Patentamt

European Patent Office

Office européen des brevets

(11) Publication number: **0 437 949 A1**

# EUROPEAN PATENT APPLICATION

(21) Application number: 90313694.3

(22) Date of filing: 14.12.90

(51) Int. Cl.⁵: **H01L 21/74, H01L 21/22**

(30) Priority: 18.12.89 US 452522

(43) Date of publication of application:
24.07.91 Bulletin 91/30

(84) Designated Contracting States:
DE FR GB IT NL

(71) Applicant: HONEYWELL INC.
Honeywell Plaza
Minneapolis MN 55408(US)

(72) Inventor: Johnson, Ralph H.
211 Ridgeview Drive
Plano, Texas 75094(US)

(74) Representative: Fox-Male, Nicholas Vincent
Humbert
Honeywell Control Systems Limited Charles
Square
Bracknell Berkshire RG12 1EB(GB)

(54) **Double diffused lead-out for a semiconducteur device.**

(57) A structure and a device which allow low resistance connection to internal circuit devices comprising a double diffused leadout is described. The first leadout diffusion (17,18) is lightly doped with dopant from either chemical group III or V to constitute N- or P- type material respectively. The lightly doped region has a high resistivity. The second diffusion (13,14) is diffused, using a dopant from the same chemical group as the first dopant, into the first diffusion. The second diffusion is diffused with enough dopant to constitute $N^+$ or $P^+$ material and has a low resistivity. The double diffused leadout creates a low resistance connection to the internal circuitry of an IC device while maintaining breakdown with the protective overlayer (31).

EP 0 437 949 A1

Xerox Copy Centre

# DOUBLE DIFFUSED LEADOUT FOR A SEMICONDUCTOR DEVICE

## BACKGROUND OF THE INVENTION

This invention is related to the field of semiconductor devices. More specifically, the invention is a leadout for diffused circuit elements in semiconductor devices which reduces surface effects and parasitic resistance and a method of making the leadout.

Semiconductor devices have defined paths of low resistivity which can be used as interconnections to external circuitry. Generally, the leadout is created by highly doping a region of the device by diffusing extra donors or acceptors into a portion of the semiconductor device. However, this diffusion must have a long tail with a small grading coefficient so that breakdown with a protective overlayer can be avoided. To avoid breakdown, a deep diffusion is required. A deep diffusion requires long diffusion times and the depth of the diffusion is limited by the depth of the device. Because of the time required and a maximum depth constraint, there is a minimum sheet resistance which is obtainable. It is desirable to have a lower sheet resistance leadout to reduce the drift caused by electrical surface effects over the contacting material and to reduce parasitic resistance.

## SUMMARY OF THE INVENTION

The invention is a double diffused leadout which is comprised of two parts. First, a high resistivity lightly doped diffusion is deeply diffused into the semiconductor device. Then, a second low resistivity heavily doped diffusion is diffused into the first diffusion, but out of contact with the protective overlayer. Breakdown voltage with the overlayer is maintained while introducing a low resistance contact to the circuit elements contained within the semiconductor device.

## BRIEF DESCRIPTION OF THE DRAWINGS

Figure 1 shows an external top view of a semiconductor device having the inventive leadouts or contacts.

Figures 2A through 2D show the semiconductor device in various stages of the construction. Figure 2d shows the semiconductor device of Figure 1 along the line 2D-2D.

Figure 3 shows a schematic diagram representation of the electrical circuit used in the illustrative device.

## DETAILED DESCRIPTION OF THE DRAWINGS

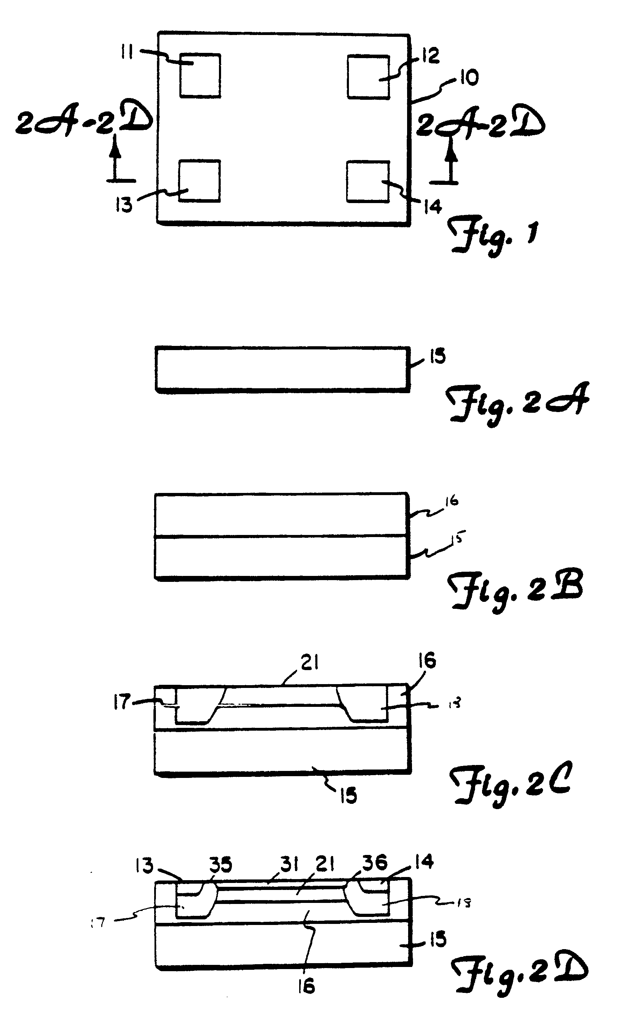

Referring now to Figure 1, there shown is a top view exterior of a semiconductor device 10 having leadouts 11, 12, 13 and 14 comprising the present invention. For this embodiment, the semiconductor device has a representative number of four of the inventive leadouts.

Turning now to Figures 2A through 2D there shown is the semiconductor device including the leadouts or contacts of the present invention. For purposes of this description, the semiconductor device to be described will be a pressure transducer, although other semiconductor devices could use the present invention as well.

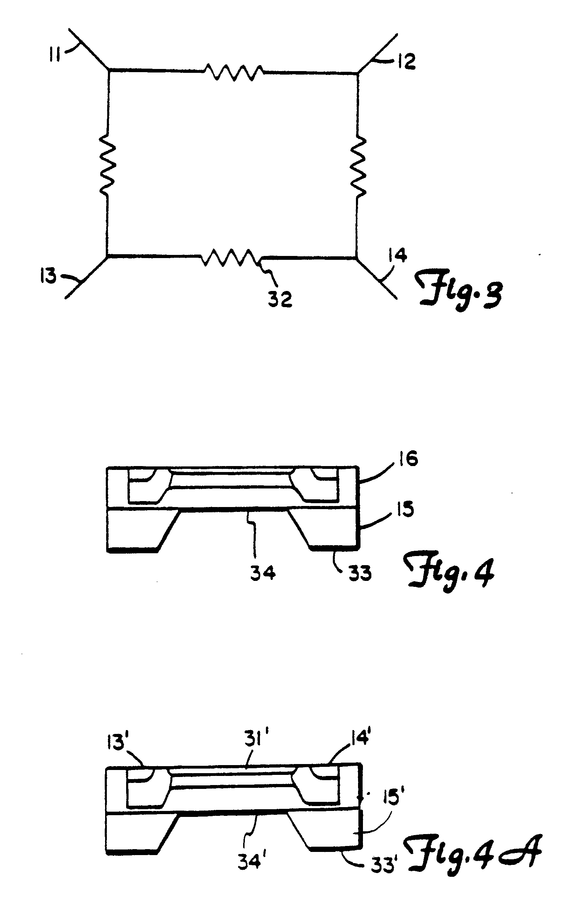

In Figure 2A, a substrate of material 15 is formed. Here, there is a doped substrate with a group III element such as boron to create p type material. Note, that for this step, or any of the other steps, an opposite conductivity type may be used from the one described if opposite conductivity types are used throughout the device such as is shown in Figure 4A. Next, a layer of n type material 16, formed by doping silicon with a group V element such as phosphorus, is grown on or placed next to and bonded to the p type substrate. This is shown in figure 2B. The n type layer may be bonded to the substrate by methods such as wafer to wafer bonding or epitaxial growth.

Figure 2C shows two diffusions 17 and 18 of lightly doped or p- type material into the n type layer. Resistor 21 of p- material is diffused into the n type layer between regions 17 and 18. The diffusion of resistor 21 may also be performed after the diffusion of leadouts 13 and 14. Note that diffusions 17 and 18 are diffused deeper into the n layer than is resistor 21.

Figure 2D shows the device as viewed along line 2D-2D of figure 1 at completion. P + leadouts 13 and 14 consisting of silicon having a high doping of boron, are diffused into regions 17 and 18 of the p- diffusion. In addition, an n type overlayer 31 is diffused into resistor 21 and may extend outside resistor 21 orthogonally to the plane of the drawing to contact the n layer 16. The overlayer 31 does not contact either of the p + leadouts 13 and 14, and is separated from the n layer 16 by portions 35 and 36 of p- diffusions 17 and 18 and resistor 21. Figure 3 shows a schematic representation of the circuit created by the above described device. Note that the structure shown as existing along line 2D-2D is present between any selected contact and the two contacts lying on mutually orthogonal lines extending from the contact.

Finally, to complete the transducer, a portion of the p substrate is etched away leaving a rim 33 supporting a diaphragm 34 containing the resistors.

This can be seen in Figure 4.

It should also be noted that the present novel leadout can be used where a low resistance leadout to a circuit element having an opposite conductivity type from the overlayer is desired.

An example of the peak doping levels for the best mode presently contemplated by the inventor would be:

p type material = $1 \times 10^{19}$ atoms/cm$^3$ group III element

p+ type material = $1 \times 10^{20}$ atoms/cm$^3$ group III element

p- type material = $7.00 \times 10^{17}$ atoms/cm$^3$ group III element

n type material = $2 \times 10^{15}$ atoms/cm$^3$ group V element

overlayer n type $7 \times 10^{17}$. Since these are diffusion regions, the doping profiles have significant widths, the average doping level being less than the peak doping leve

The above doping levels are meant to be representative, not exclusive. Other combinations will be obvious to one of ordinary skill in the art.

The foregoing has been a description which allows one of ordinary skill in the art to make and use the described contact. However, the applicant only intends to limit the invention by the claims appended hereto.

## Claims

1. A semiconductor device, characterised by:
   a substrate formed from silicon having a first conductivity type and a first doping level, said substrate further having a first major surface;
   a first layer formed on said first major surface from silicon having a second conductivity type, said first layer having a second major surface and said first doping level;
   a resistor formed from silicon having said first conductivity type formed in said first layer;
   an overlayer formed from silicon having said second conductivity type formed in said first layer at said second major surface;
   a first diffusion formed within said first layer from silicon having a first conductivity type and a second doping level, said first diffusion being electrically connected with said resistor; and
   a second diffusion formed from silicon having the same conductivity type as said first diffusion but a third doping level which is more heavily doped than both of said first and second doping levels, said second diffusion being formed in at least a portion of said first diffusion and out of physical contact with said overlayer, said second diffusion being usable as a leadout and contact for external circuitry.

2. A semi-conductor device according to Claim 1, wherein the leadout is characterised in that:
   said first conductivity type is silicon doped with a group V element, said first doping level requiring that the silicon be doped with a normal amount of dopant to constitute n material; and said second conductivity type is silicon doped with a group III type element, said second doping level requiring that the silicon be lightly doped to constitute lightly doped p material, and said third doping level requiring that the silicon be doped with sufficient dopant to constitute heavily doped p material.

3. A semiconductor device, characterised by:
   a substrate formed from silicon having a first conductivity type and a first doping level, said substrate further having a first major surface;
   a first layer formed on said first major surface from silicon having a second conductivity type, said first layer having a second major surface and said first doping level;
   a resistor formed from silicon having said first conductivity type, said resistor being formed in said first layer;
   an overlayer formed from silicon having said second conductivity type formed in said first layer at said second major surface;
   a first diffusion formed within said first layer from silicon having a first conductivity type and a second doping level, said first diffusion being electrically connected with said resistor; and
   a second diffusion formed from silicon having the same conductivity type as said first diffusion but a third doping level which is more heavily doped than both of said first and second doping levels, said second diffusion being formed in at least a portion of said first diffusion and being formed so that a portion of said first diffusion isolates said second diffusion from said overlayer.

4. A method of making a semiconductor device, characterised by the steps of:
   forming a substrate out of material having a first conductivity type and said first doping level, said substrate being formed to have a first major surface;
   forming a first layer comprised of material having a second conductivity type and a first doping level, said first layer being located at said first major surface and having a central region and edge regions;
   forming first and second regions comprised of material having said first conductivity type and a second doping level in said first layer, said second doping level being more lightly doped than said first doping level, said first and second regions being diffused in said first layer at said edge regions;

forming first and second leadouts having said first conductivity type but a third doping level being more heavily doped than both said first and second doping level;

forming a resistor in said first layer between and in contact with said first and second regions; and

forming an overlayer into at least the central region of said first layer, said overlayer having said second conductivity type and being separated from said first and second leadouts by a portion of said first and second regions.

Fig. 1

Fig. 2A

Fig. 2B

Fig. 2C

Fig. 2D

Fig. 3

Fig. 4

Fig. 4A

European
Patent Office

EUROPEAN SEARCH
REPORT

Application Number

EP 90 31 3694

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 168 678 (IBM) <br> * page 5, line 23 - page 6, line 35; figures 1, 2 * <br> — — — | 1-4 | H <br> 01 L 21/74 <br> H 01 L 21/22 |
| Y | ONDE ELECTRIQUE. vol. 67, no. 6, November 1987, PARIS FR pages 58 - 69; Pierre ROSSEL: "MOS technologies for smart power and high voltage circuits" <br> * page 62; figure 5 * <br> — — — | 1-4 | |
| A | US-A-4 868 624 (BERNARD L. GRUNG ET AL.) <br> * column 12, lines 11 - 21; figure 3 * <br> — — — | 1-4 | |
| A | US-A-4 143 455 (ULRICH SCHWABE ET AL.) <br> * column 3, line 51 - column 4, line 3; figures 4, 5 * <br> — — — | 1-3 | |
| A | IBM TECHNICAL DISCLOSURE BULLETIN. vol. 22, no. 8A, January 1980, NEW YORK US pages 3138 - 3139; D.L. BERGERON et al.: "Bipolar compatible N-channel JFET with merged T2L logic gate" <br> * the whole document * <br> — — — — — | 1-3 | |
| | | | TECHNICAL FIELDS SEARCHED (Int. Cl.5) <br><br> H 01 L <br> G 01 L |

The present search report has been drawn up for all claims

| Place of search | Date of completion of search | Examiner |
|---|---|---|
| Berlin | 13 March 91 | KLOPFENSTEIN P R |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons
...............................................................
& : member of the same patent family, corresponding
    document